# EUROPÄISCHE PATENTANMELDUNG

(11) **EP 4 576 582 A1**
(43) Veröffentlichungstag der Anmeldung: **25.06.2025**
(21) Anmeldenummer: 24221338.7
(22) Anmeldetag: 19.12.2024
(51) Int. Cl.: H03M 1/16, H03M 1/36

(54) **VERFAHREN ZUR WANDLUNG EINES ANALOGEN SIGNALS**

(30) Priorität: 21.12.2023 DE 102023136327
(71) Anmelder: Forschungszentrum Jülich GmbH, 52428 Jülich (DE)
(72) Erfinder: Grewing, Christian, 52428 Jülich (DE)
(74) Vertreter: dompatent von Kreisler Selting Werner - Partnerschaft von Patent- und Rechtsanwälten mbB

(57) **Zusammenfassung**

Bei dem Verfahren zur Wandlung eines konstanten oder variablen elektrischen analogen Signals, dessen Größe zwischen einem Minimalwert und einem Maximalwert liegt, wird eine erste Wandlereinheit (10) bereitgestellt, die einen Eingang (12) und mehrere Ausgänge (18.1 bis 18.8) und mehrere Fensterdiskriminatoren (16.1 bis 16.8) aufweist. Der Wertebereich wird zwischen dem Minimalwert (MIN) und dem Maximalwert (MAX) in einzelne aneinander angrenzende Teilbereiche unterteilt. Jedem Fensterdiskriminator (16.1 bis 16.8) ist ein anderer der Teilbereiche zugeordnet. Das analoge Signal (14) wird dem Eingang (12) der ersten Wandlereinheit (10) zugeführt, woraufhin derjenige Fensterdiskriminator (16.1 bis 16.8) anspricht, dem derjenige Teilbereich zugeordnet ist, innerhalb dessen die Größe des analogen Signals (14) liegt. Dieser Fensterdiskriminator (16.1 bis 16.8) gibt an seinem Ausgang (18.1 bis 18.8) das das erste Ereignis repräsentierende Ausgangssignal aus, während sämtliche anderen Fensterdiskriminatoren (16.1 bis 16.8) an ihren Ausgängen (18.1 bis 18.8) das das zweite Ereignis repräsentierende Ausgangssignal ausgeben, womit die Ausgangssignale sämtlicher Fensterdiskriminatoren (16.1 bis 16.8) zusammengesetzt ein Digitalsignal mit einer der Anzahl an Fensterdiskriminatoren (16.1 bis 16.8) gleichenden Bitanzahl ergeben.

## Beschreibung

Die Erfindung betrifft ein Verfahren zur Wandlung eines konstanten oder variablen elektrischen analogen Signals, dessen Größe zwischen einem Minimalwert und einem Maximalwert liegt. Insbesondere betrifft die Erfindung die Umsetzung eines analogen Eingangssignals in ein Multilevel-Symbol zur weiteren Verarbeitung in vorzugsweise analogen Prozessoreinheiten.

Analog-Digital-Wandler, auch ADC genannt, sind grundsätzlich bekannt. Ein solcher ADC wandelt ein analoges Signal in ein werte- und zeitdiskretisiertes Signal, so dass dieses Signal mit digitaler Signalverarbeitung bei hohem Signal-Rausch-Abstand weiterverarbeitet werden kann. Problematisch ist die Analog-Digital-Wandlung von Signalen mit hoher Bandbreite, wie sie etwa in Detektoren für medizintechnische Anwendungen oder bei der Erforschung von Materie oder Biologie anzutreffen sind. Bei neueren Generationen von PET-Detektoren kann die Bandbreite des analogen Signals im 20 GHz-Bereich liegen. Damit bei der Analog-Digital-Wandlung keinerlei Signalenergie verloren geht, muss die Abtastfrequenz gemäß dem Abtasttheorem doppelt so hoch wie die höchsten Frequenzanteile des analogen Signals sein. Gleichzeitig ist für beispielsweise eine Parameter-Extraktion eines Ereignisses aus dem Signal ein Signal-Rausch-Abstand von 70 dB bis 89 dB häufig notwendig. Entsprechende ADCs mit einer dementsprechend hohen Abtastrate und z.B. 12 Bit Auflösung (Effective Number of Bits (ENOB)) verbrauchen vergleichsweise viel Energie und Platz, womit die Signalwandlung nicht mehr im Sensor oder allgemeiner ausgedrückt am Ort des Entstehens des zu wandelnden analogen Signals erfolgen kann. Will man die digitale Signalverarbeitung "sensornah" durchführen, wäre dies mit dem Nachteil verbunden, dass die Übertragung der digitalen Daten mit hoher Bandbreite vergleichsweise viel Energie verbraucht und nachteiligerweise Latenzen erzeugt.

Ein Verfahren zur Erkennung von Fehlern eines ADC ist aus US-A-2011/0291868 (DE-A-10 2010 029 497) bekannt. Gemäß diesem Verfahren wird aus einem analogen Eingangssignal mit einem Eingangswert Uᵢₙ ein digitales Ausgangssignal erzeugt, das eine Zahl z repräsentiert. Der Wertebereich für sämtliche möglichen Eingangswerte Uᵢₙ ist in Unterbereiche aufgeteilt; genauso sind sämtliche möglichen Zahlen z in Unterbereiche aufgeteilt. Ein Eingangswert Uᵢₙ und eine dazu korrespondierende Zahl z sind jeweils einander korrespondierenden Unterbereichen zugeordnet. Ein Fehler wird nun erkannt, wenn die Zahl z und der Eingangswert Uᵢₙ Unterbereichen zugeordnet sind, die nicht zueinander korrespondieren.

Aufgabe der Erfindung ist es, ein verbessertes Verfahren zur Wandlung eines elektrischen analogen Signals in ein Signal anzugeben, das eines von mehreren möglichen Symbolen aufweisen.

Zur Lösung dieser Aufgabe wird mit der Erfindung ein Verfahren zur Wandlung eines konstanten oder variablen elektrischen analogen Signals vorgeschlagen, dessen Größe zwischen einem Minimalwert und einem Maximalwert liegt und bei dem Verfahren
- eine erste Wandlereinheit bereitgestellt wird, die einen Eingang und eine Vielzahl von Ausgängen sowie eine dieser Vielzahl gleichende Anzahl an Fensterdiskriminatoren aufweist,
- der Wertebereich zwischen dem Minimalwert und dem Maximalwert in einzelne aneinander angrenzende Teilbereiche unterteilt wird,
- wobei jedem Fensterdiskriminator ein anderer der Teilbereiche zugeordnet ist und wobei jeder Fensterdiskriminator als Reaktion auf den Empfang des analogen Signals an dem Eingang der Wandlereinheit anspricht und jeder der Fensterdiskriminatoren an seinem Ausgang ein binäres Signal ausgibt, das ein erstes oder ein zweites Ereignis repräsentiert,
- das analoge Signal dem Eingang der ersten Wandlereinheit zugeführt wird und daraufhin derjenige Fensterdiskriminator anspricht, dem derjenige Teilbereich zugeordnet ist, innerhalb dessen die Größe des analogen Signals liegt, und
- dieser Fensterdiskriminator an seinem Ausgang das das erste Ereignis repräsentierende Ausgangssignal ausgibt und sämtliche anderen Fensterdiskriminatoren an ihren Ausgängen das das zweite Ereignis repräsentierende Ausgangssignal ausgeben, womit die Ausgangssignale sämtlicher Fensterdiskriminatoren zusammengesetzt ein Digitalsignal mit einer der Anzahl an Fensterdiskriminatoren gleichenden Bitanzahl ergeben.

Nach der Erfindung wird eine (erste) Wandlereinheit bereitgestellt, die einen Eingang und eine Vielzahl von Ausgängen sowie eine dieser Vielzahl gleichende Anzahl an Fensterdiskriminatoren aufweist. Der Wertebereich zwischen dem Minimalwert und dem Maximalwert des analogen Eingangssignals wird in einzelne aneinander angrenzende Teilbereiche unterteilt, wobei jedem Fensterdiskriminator ein anderer der Teilbereiche zugeordnet ist. Mit anderen Worten spricht also stets derjenige (einzige) Fensterdiskriminator an, der demjenigen Teilbereich zwischen dem Minimalwert und dem Maximalwert des analogen Eingangssignals zugeordnet ist, innerhalb dessen die aktuelle Größe des Eingangssignals liegt.

Jeder Fensterdiskriminator spricht also als Reaktion auf den Empfang des analogen Signals am Eingang der Wandlereinheit an und gibt an seinem Ausgang ein binäres Signal aus, das entweder ein erster oder ein zweites Ereignis repräsentiert. Das erste Ereignis besagt beispielsweise, dass sich die aktuelle Größe des Eingangssignals in demjenigen Teilbereich befindet, dem der Fensterdiskriminator zugeordnet ist. Bei Eintritt des ersten Ereignisses spricht also der Fensterdiskriminator an, während er im Falle des Eintritts des zweiten Ereignisses nicht anspricht. Am Ausgang jedes Fensterdiskriminators steht also entweder das binäre Signal für "logisch 1" oder das binäre Signal für "logisch 0" an.

Zu jedem Zeitpunkt bilden demnach die Ausgänge sämtlicher Fensterdiskriminatoren ein digitales Signal mit mehreren Bits, von denen jeweils eines "logisch 1" entspricht und die anderen "logisch 0" entsprechen. Damit unterscheidet sich das Digitalsignal am Ausgang der Wandlereinheit ganz eindeutig von dem Ausgangssignal eines typischen ADC, indem nach der Erfindung der durch das Digitalsignal repräsentierte Wert bei weitem nicht dem Wert bzw. der Größe des Analogsignals entspricht.

In vorteilhafter Weiterführung der Erfindung kann vorgesehen sein, dass die Teilbereiche gleich groß oder unterschiedlich groß sind.

Die "Auflösung" des analogen Eingangssignals mit nur einer Wandlereinheit kann noch vergleichsweise recht grob sein, weshalb es von Vorteil ist, den sogenannten Residual-Anteil in einer zweiten Wandlereinheit ebenfalls zu wandeln. Hierzu ist bei einer vorteilhaften Ausgestaltung der Erfindung vorgesehen,
- dass eine zweite Wandlereinheit, die funktionsgleich der ersten Wandlereinheit ist, bereitgestellt wird,
- dass das Digitalsignal der ersten Wandlereinheit einer Digital-Analog-Wandlung unterzogen wird und danach als ein analoges Zwischensignal vorliegt,
- dass die Differenz aus dem analogen Eingangssignal und dem Zwischensignal als analoges Differenzsignal gebildet wird und
- dass das analoge Differenzsignal verstärkt und das so verstärkte analoge Differenzsignal dem Eingang der zweiten Wandlereinheit zugeführt wird.

Gemäß diesem Ausführungsbeispiel der Erfindung wird also jeweils die Differenz des gewandelten Signals zum analogen Eingangssignal ermittelt. Hierzu wird das am Ausgang der ersten Wandlereinheit anstehende Digitalsignal einer Digital-Analog-Wandlung unterzogen, womit ein analoges Zwischensignal vorliegt. Nun wird die Differenz zwischen Zwischensignal und analogem Eingangssignal als analoges Differenzsignal gebildet, das der zweiten Wandlereinheit zugeführt wird, an deren Ausgang dann wiederum ein Digitalsignal ansteht. Hiermit ist die Auflösung des analogen Eingangssignals erhöht.

Es ist möglich, das analoge Differenzsignal um einen Faktor zu verstärken, der gleich der Anzahl der Fensterdiskriminatoren der ersten Wandlereinheit ist.

In entsprechender Weise kann nun das Ausgangssignal der zweiten Wandlereinheit nochmals gewandelt werden, was gemäß einer entsprechenden Weiterbildung der Erfindung dazu führt,
- dass eine dritte Wandlereinheit, die funktionsgleich der ersten und der zweiten Wandlereinheit ist, bereitgestellt wird,
- dass das aus den Ausgangssignalen sämtlicher Fensterdiskriminatoren der zweiten Wandlereinheit zusammengesetzte Digitalsignal einer Digital-Analog-Wandlung unterzogen wird und als ein weiteres analoges Zwischensignal vorliegt,
- dass die Differenz aus dem verstärkten analogen Differenzsignal am Eingang der zweiten Wandlereinheit und dem weiteren Zwischensignal gebildet wird und
- dass dieses analoge Differenzsignal verstärkt und das so verstärkte analoge Differenzsignal der dritten Wandlereinheit zugeführt wird.

Schließlich sei auf eine weitere vorteilhafte Ausgestaltung der Erfindung hingewiesen, bei der für die mehreren Wandlereinheit gilt, dass
- die Wertebereiche, innerhalb der die jeweiligen Eingangssignale liegen können, gleich oder ungleich sind, und/oder
- die Anzahl der Teilbereiche gleich oder ungleich ist und/oder
- die Größe der Teilbereiche gleich oder ungleich ist.

Mit der Erfindung kann die Wandlung analoger Signale mit ähnlich hohem Signal-Rausch-Abstand und ähnlich hoher Linearität in ihren Rechnungsschritten erfolgen, wie dies bei der digitalen Signalverarbeitung anzutreffen ist. Bisher ist die analoge Signalverarbeitung häufig begrenzt auf eine Signal-Vorverarbeitung wie Verstärkung, Frequenzumsetzung und Filterung. Mit modernen Multilevel- oder Analog-Signalverarbeitungen aber lassen sich manche Rechenschritte, wie z.B. Korrelationen zur Ereigniserkennung und anderer allgemeiner Mustererkennung mit hoher Geschwindigkeit und Bandbreite ohne Digitalisierungsrauschen umsetzen. Hier sind die Vorteile der Erfindung zu sehen. Auch für Aufgaben, die durch gepulste neuronale Netze umgesetzt werden, muss ein analoges Eingangssignal häufig erst so gewandelt werden, dass es den Signalanforderungen derartiger neuronaler Netze entspricht, etwa z.B. bezüglich Pulsweitenmodulierung anstelle einer Digitalwandlung.

Eines der Wesensmerkmale der Erfindung ist, dass die Signalwandlung mit Hilfe sogenannter Crossbar-Arrays möglich ist, mit denen das analoge Eingangssignal in ein Multilevel-Symbol umgesetzt wird oder in ein pulsweitenmoduliertes Signal umgesetzt wird. Ein Crossbar-Array bezeichnet eine Matrix aus Eingangs- und Ausgangsleitungen, bei der beispielsweise jede Eingangsleitung mit jeder Ausgangsleitung verknüpft ist. Diese Verknüpfungen können unterschiedlich gewichtet sein. Z.B. kann eine Eingangsleitung auf einer Ausgangsleitung ein anderes Signal erzeugen als auf einer anderen Ausgangsleitung. Diese Verknüpfung kann z.B. eine Multiplikation des Eingangssignals mit einem Widerstand sein, der zwischen den jeweiligen Eingangs- und Ausgangsleitungen liegt. Der Widerstandswert kann z.B. durch einen Memristor realisiert und programmiert sein; es sind aber auch z.B. photonisch Kopplungen möglich. Es kann aber auch ein analoger Assoziativspeicher genutzt werden, um ein analoges Eingangssignal in Werte zu diskretisieren. Mit einer, wie oben beschrieben, weiteren Stufe der Wandlung kann die Auflösung erhöht werden. Die Wandlung kann unter Anwendung einer Zeitdiskretisierung oder aber auch ohne eine solche erfolgen.

Die Erfindung wird nachfolgend anhand eines Ausführungsbeispiels und unter Bezugnahme auf die Zeichnung näher erläutert. Im Einzelnen zeigen dabei:
- Fig. 1: eine blockschaltbildähnliche schaltungstechnische Übersicht der Verknüpfung zweier Wandlerstufen gemäß der Erfindung,
- Fig. 2: eine Darstellung der erfindungsgemäßen Wandlung eines beispielsweise sinusförmigen analogen Eingangssignals und
- Fig. 3: eine vergrößerte Darstellung des Ausschnitts III der Fig. 2

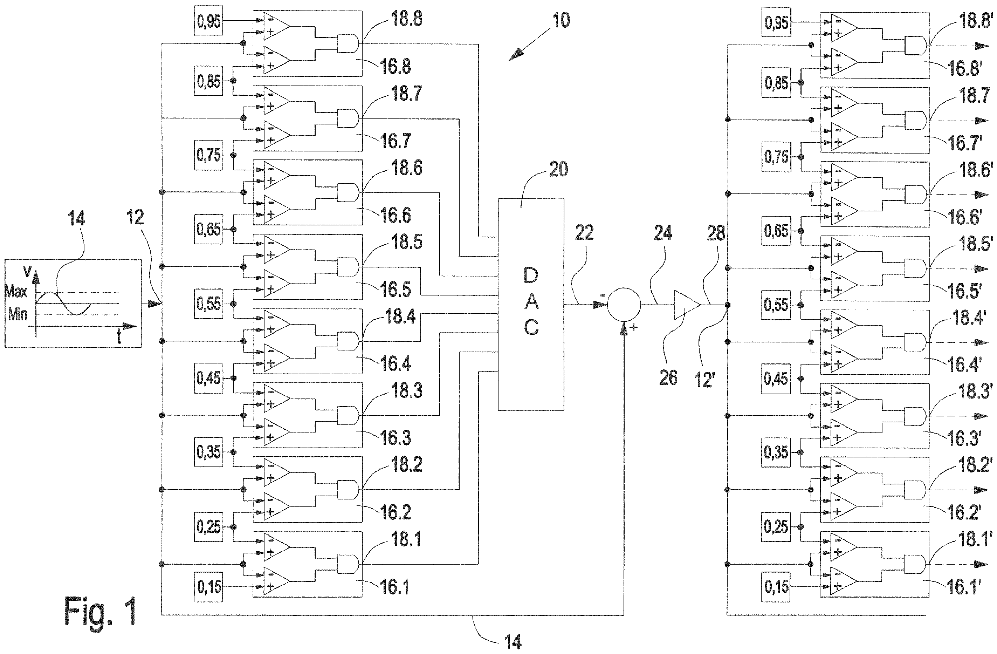

In Fig. 1 sind zwei Wandlereinheiten 10, 10' gezeigt, die erfindungsgemäß arbeiten und hinsichtlich ihres Aufbaus identisch sind. Nachfolgend wird die Wandlereinheit 10 beschrieben, wobei deren Details entsprechend auch in der Wandlereinheit 10' zu finden sind. Die Komponenten der Wandlereinheit 10' sind mit den gleichen Bezugszeichen versehen wie im Falle der Wandlereinheit 10. Die Bezugszeichen für die Wandlereinheit 10' gleichen denen für der Wandlereinheit 10, sind jedoch mit dem Zusatz ' versehen.

Die Wandlereinheit 10 weist einen Eingang 12 auf, dem ein beispielshaft bei 14 gezeigtes Analogsignal zugeführt wird. Das Analogsignal 14 weist zeitabhängig unterschiedliche Werte auf, die zwischen einem Minimalwert MIN und einem Maximalwert MAX liegen. Bei dem Analogsignal 14 handelt es sich in diesem Ausführungsbeispiel um ein sinusförmiges Signal.

Die Wandlereinheit 10 ist ferner mit mehreren Fensterdiskriminatoren 16.1 bis 16.8 versehen, die unterschiedliche untere Schwellwerte und obere Schwellwerte aufweisen. Jeder Schwellwertbereich jedes Fensterdiskriminators 16.1 bis 16.8 deckt einen anderen Teilbereich des Wertebereichs zwischen MIN und MAX ab. Liegt der aktuelle Wert des Analogsignals 14 innerhalb eines dieser Schwellwertbereiche, so spricht der betreffende Fensterdiskriminator an und liefert an seinem Ausgang 18.1 bis 18.8 ein binäres Signal, das entweder den Zustand "logisch 1" oder den Zustand "logisch 0" annimmt.

Die Ausgänge 18.1 bis 18.8 der Wandlereinheit 10 liefern also jeweils aktuelle Digitalsignale mit in diesem Ausführungsbeispiel 8 Bits, von denen jeweils ein Bit den Wert "logisch 1" und die anderen Bits den Wert "logisch 0" annehmen.

Dieses Digitalsignal wird nun einem Digital-Analog-Wandler 20 zugeführt, der an seinem Ausgang ein analoges Zwischensignal 22 ausgibt.

In dem Ausführungsbeispiel gemäß Fig. 1 wird dieses analoge Zwischensignal 22 von dem Analogsignal 14 subtrahiert, womit ein analoges Differenzsignal 24 gebildet wird, das mittels eines Verstärkers 26 verstärkt wird. Das verstärkte analoge Differenzsignal 28 wird dem Eingang 12 der Wandlereinheit 10' zugeführt, womit das Differenzsignal daraufhin untersucht wird, in welchem Teilbereich des Wertebereichs es größenmäßig liegt.

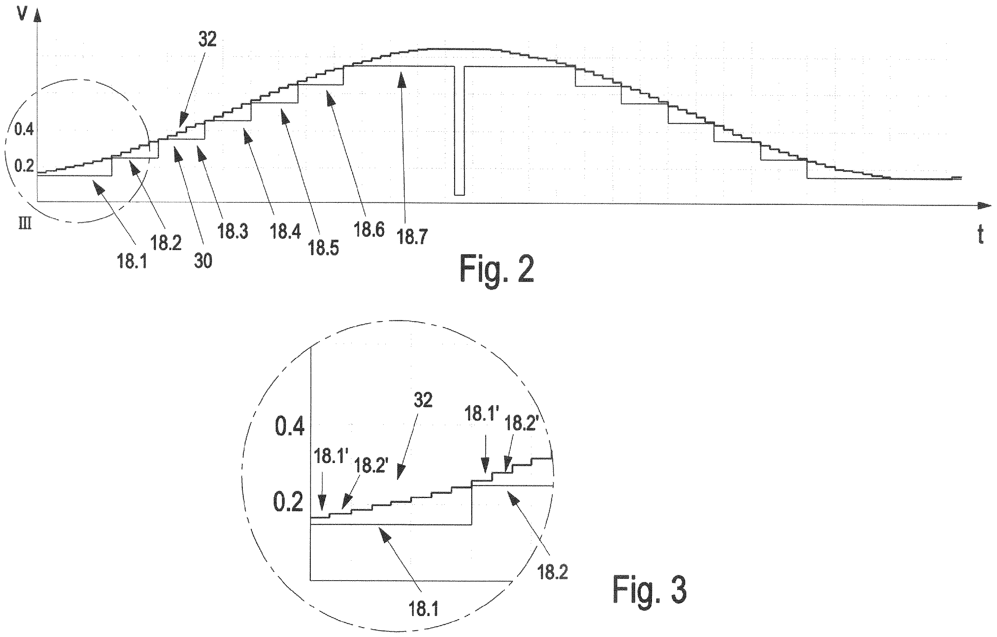

Fign. 2 und 3 zeigen das Ergebnis der Doppelwandlerstruktur der Fig. 1 für die Wandlung des analogen Eingangssignals 14. Nach Wandlung der binären Signale an den Ausgängen 18.1 bis 18.8 der (ersten) Wandlereinheit 10 ergibt sich der "grobe" treppenartige Signalverlauf 30 des Zwischensignals 22. Solange das analoge Eingangssignal 14 in diesem Ausführungsbeispiel größer als 0,15 V und kleiner als 0,25 V ist, spricht der Fensterdiskriminator 16.1 an. Steigt der Wert des analogen Eingangssignals 14 über 2,25 V und bleibt unter 0,35 V, spricht der zweite Fensterdiskriminator 16.2 an, usw. Diese Systematik setzt sich dann in der (zweiten) Wandlereinheit 10' entsprechend feiner granular fort, wie es in den Fign. 2 und 3 für den zweiten treppenförmigen Kurvenverlauf 32 gezeigt ist.

In den Fign. 2 und 3 ist durch die Bezugszeichen 18.1 bis 18.7 und 18.1' sowie 18.2' und die Pfeile angedeutet, welcher Ausgang der ersten bzw. zweiten Wandlereinheit 10, 10' für den jeweiligen betreffenden treppenförmigen Abschnitt der Signale 30, 32 verantwortlich ist.

Auf diese Art und Weise lässt sich also mit dem erfindungsgemäßen Wandlerkonzept für analoge Signale mit vergleichsweise geringem schaltungstechnischem Aufwand und unter Einsatz vergleichsweise geringer elektrischer Energie eine schnelle und hochratige Umsetzung eines analogen Signals für die weitere Verarbeitung realisieren.

### BEZUGSZEICHENLISTE

- 10, 10': Wandlereinheit
- 12, 12': Eingang
- 14: analoges Eingangssignal
- 16.1, 16.1': Fensterdiskriminator
- 16.2, 16.2': Fensterdiskriminator
- 16.3, 16.3': Fensterdiskriminator
- 16.4, 16.4': Fensterdiskriminator
- 16.5, 16.5': Fensterdiskriminator
- 16.6, 16.6': Fensterdiskriminator
- 16.7, 16.7': Fensterdiskriminator
- 16.8, 16.8': Fensterdiskriminator
- 18.1, 18.1': Fensterdiskriminatorausgang
- 18.2, 18.2': Fensterdiskriminatorausgang
- 18.3, 18.3': Fensterdiskriminatorausgang
- 18.4. 18.4': Fensterdiskriminatorausgang
- 18.5, 18.5': Fensterdiskriminatorausgang
- 18.6, 18.6': Fensterdiskriminatorausgang
- 18.7, 18.7': Fensterdiskriminatorausgang
- 18.8, 18.8': Fensterdiskriminatorausgang
- 20: Digital-Analog-Wandler
- 22: Zwischensignal
- 24: Differenzsignal
- 26: Verstärker
- 28: Differenzsignal
- 30: Signalverlauf
- 32: Kurvenverlauf
- MIN: Minimalwert
- MAX: Maximalwert

## Patentansprüche

1. Verfahren zur Wandlung eines konstanten oder variablen elektrischen analogen Signals, dessen Größe zwischen einem Minimalwert und einem Maximalwert liegt, wobei bei dem Verfahren
- eine erste Wandlereinheit (10) bereitgestellt wird, die einen Eingang (12) und eine Vielzahl von Ausgängen (18.1 bis 18.8) sowie eine dieser Vielzahl gleichende Anzahl an Fensterdiskriminatoren (16.1 bis 16.8) aufweist,
- der Wertebereich zwischen dem Minimalwert (MIN) und dem Maximalwert (MAX) in einzelne aneinander angrenzende Teilbereiche unterteilt wird,
- wobei jedem Fensterdiskriminator (16.1 bis 16.8) ein anderer der Teilbereiche zugeordnet ist und wobei jeder Fensterdiskriminator (16.1 bis 16.8) als Reaktion auf den Empfang des analogen Signals (14) an dem Eingang (12) der Wandlereinheit (10) anspricht und jeder der Fensterdiskriminatoren (16.1. bis 16.8) an seinem Ausgang (18.1 bis 18.8) ein binäres Signal ausgibt, das ein erstes oder ein zweites Ereignis repräsentiert,
- das analoge Signal (14) dem Eingang (12) der ersten Wandlereinheit (10) zugeführt wird und daraufhin derjenige Fensterdiskriminator (16.1 bis 16.8) anspricht, dem derjenige Teilbereich zugeordnet ist, innerhalb dessen die Größe des analogen Signals (14) liegt, und
- dieser Fensterdiskriminator (16.1 bis 16.8) an seinem Ausgang (18.1 bis 18.8) das das erste Ereignis repräsentierende Ausgangssignal ausgibt und sämtliche anderen Fensterdiskriminatoren (16.1 bis 16.8) an ihren Ausgängen (18.1 bis 18.8) das das zweite Ereignis repräsentierende Ausgangssignal ausgeben, womit die Ausgangssignale sämtlicher Fensterdiskriminatoren (16.1 bis 16.8) zusammengesetzt ein Digitalsignal mit einer der Anzahl an Fensterdiskriminatoren (16.1 bis 16.8) gleichenden Bitanzahl ergeben.

2. Verfahren nach Anspruch 1, **dadurch gekennzeichnet, dass** die Teilbereiche gleich groß oder unterschiedlich groß sind.

3. Verfahren nach Anspruch 1 oder 2, **dadurch gekennzeichnet,**
- **dass** eine zweite Wandlereinheit (10'), die funktionsgleich der ersten Wandlereinheit (10) ist, bereitgestellt wird,
- **dass** Digitalsignal der ersten Wandlereinheit (10) einer Digital-Analog-Wandlung unterzogen wird und danach als ein analoges Zwischensignal (22) vorliegt,
- **dass** die Differenz aus dem analogen Eingangssignal (14) und dem Zwischensignal (22) als analoges Differenzsignal (24) gebildet wird und
- **dass** das analoge Differenzsignal (24) verstärkt und das so verstärkte analoge Differenzsignal (28) dem Eingang (12') der zweiten Wandlereinheit (10') zugeführt wird.

4. Verfahren nach Anspruch 3, **dadurch gekennzeichnet, dass** das analoge Differenzsignal (24) um einen Faktor verstärkt wird, der gleich der Anzahl der Fensterdiskriminatoren (16.1 bis 16.8) der ersten Wandlereinheit (10) ist.

5. Verfahren nach Anspruch 3 oder 4, **dadurch gekennzeichnet,**
- **dass** eine dritte Wandlereinheit, die funktionsgleich der ersten und der zweiten Wandlereinheit ist, bereitgestellt wird,
- **dass** das aus den Ausgangssignalen sämtlicher Fensterdiskriminatoren der zweiten Wandlereinheit zusammengesetzte Digitalsignal einer Digital-Analog-Wandlung unterzogen wird und als ein weiteres analoges Zwischensignal vorliegt,
- **dass** die Differenz aus dem verstärkten analogen Differenzsignal am Eingang der zweiten Wandlereinheit und dem weiteren Zwischensignal gebildet wird und
- **dass** dieses analoge Differenzsignal verstärkt und das so verstärkte analoge Differenzsignal der dritten Wandlereinheit zugeführt wird.

6. Verfahren nach einem der Ansprüche 1 bis 5, **dadurch gekennzeichnet, dass** bei mehreren Wandlereinheiten (10, 10')
- die Wertebereiche, innerhalb der die jeweiligenEingangssignale liegen können, gleich oder ungleich sind, und/oder
- die Anzahl der Teilbereiche gleich oder ungleich ist und/oder
- die Größe der Teilbereiche gleich oder ungleich ist.
